(19)

Europäisches Patentamt
European Patent Office
Office européen des brevets

(11)  **EP 4 601 417 A1**

(12)  **EUROPEAN PATENT APPLICATION**

(43) Date of publication:
**13.08.2025  Bulletin 2025/33**

(21) Application number: **24223276.7**

(22) Date of filing: **25.12.2024**

(51) International Patent Classification (IPC):
**H05B 45/40** *(2020.01)*

(52) Cooperative Patent Classification (CPC):
**H05B 45/40; H05B 45/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **07.02.2024  CN 202410175745**

(71) Applicant: **Shangyou Jiayi Lighting Product Co.,
Ltd.
Huangbu Town, Shangyou County
Ganzhou City
Jiangxi 314000 (CN)**

(72) Inventor: **HE, Yaowen
Ganzhou, 341000 (CN)**

(74) Representative: **Huang, Liwei
Cäcilienstraße 12
40597 Düsseldorf (DE)**

(54)  **LIGHT STRING WITH REDUCED POWER CONSUMPTION AND IMPROVED BRIGHTNESS**

(57)  Provided is a light string with reduced power consumption and improved brightness, including: at least a first LED luminous body and a second LED luminous body in parallel, wherein each LED luminous body includes at least a resistor, a first LED light emitting chip and a second LED light emitting chip, and each LED luminous body is free of a current-limiting IC chip, wherein the first LED light emitting chip and the second LED light emitting chip each include a plurality of LED light beads of the same specification in series, the first LED light emitting chip includes m LED light beads in series, and the second LED light emitting chip includes n LED light beads in series, and the resistor is in a series relationship with the first LED light emitting chip and the second LED light emitting chip. The light string of the present disclosure can be operated at a current of 0.3 mA or less, and a total power of the light string is as low as 7 W, which is significantly lower than that of a light string in the prior art.

FIG. 1

EP 4 601 417 A1

## Description

## FIELD OF THE INVENTION

The present disclosure relates to LED light strings, in particular to a light string with reduced power consumption and improved brightness.

## BACKGROUND OF THE INVENTION

In the prior art, in order to achieve stronger load-carrying capability of LED light strings and consistent brightness of front and rear light beads, the following solution is mainly adopted:
taking LED light beads of 3V as an example, the LED light beads of 3V are connected in series into modules of corresponding voltage levels, the more the light beads, the higher the voltage level, and the average brightness of the light beads is always ensured; the same modules are then connected in parallel to form the final light string.
The advantages of this solution are that the consistency of brightness is ensured is ensured by connecting the light beads inside each module in series, and proper cutting characteristics of the light string are ensured by the parallel connection of the modules to each other. However, the disadvantage of the series-parallel combination adopted by this solution is that the light string cannot be cut at will, and must be cut according to a specified unit or the number of lamps, and if the light string is cut incorrectly, a section of lamps will not light up, and in addition, this solution additionally requires a return line. For LEDs of 3V, taking an operating voltage of 24V and a total of 1000 LED light beads as an example, the light string obtained in this solution has a total power of 18W, which is still relatively high, and at this time, a total power of lower than 10W cannot be achieved.
In view of this, it is necessary to develop a new light string to solve the above technical problems.

## SUMMARY OF THE INVENTION

In view of this, the present disclosure provides a light string with reduced power consumption and improved brightness, including:

at least a first LED luminous body and a second LED luminous body in parallel, wherein
each LED luminous body includes at least a resistor, a first LED light emitting chip and a second LED light emitting chip, and each LED luminous body is free of current-limiting IC chip, wherein
the first LED light emitting chip and the second LED light emitting chip each include a plurality of LED light beads of the same specification in series, the first LED light emitting chip includes m LED light beads in series, and the second LED light emitting chip includes n LED light beads in series,
the resistor is in a series relationship with the first LED light emitting chip and the second LED light emitting chip,
a direct-current operating voltage of the light string is $V_s$, a target operating current If of the first LED light emitting chip and a target operating current If of the second LED light emitting chip are equal and are less than or equal to 0.3 mA, and an operating voltage of any one LED light bead in the first LED light emitting chip and the second LED light emitting chip is V:

a resistance value Rs of the resistor is selected according to the following formula:

$$R_s=(V_s-m*V-n*V)/I_{f,}$$

and the operating voltage V of any one LED light bead is slightly less than or equal to a forward voltage $V\varepsilon$ of the LED light bead.

Preferably,
the forward voltage $V\varepsilon$ of the LED light bead is 3V.
Preferably,
the direct-current operating voltage $V_s$ of the light string is greater than or equal to 24 V and less than or equal to 36 V.
Preferably,
m is not equal to n.
Preferably,
m is 6 and n is 3.
Preferably,
the resistance value $R_s$ of the resistor is 600 ohms.
Preferably,

each LED luminous body further includes a cup body, wherein
a side of a "+" end of the cup body is provided with the resistor and the first LED light emitting chip, and
a side of a "-" end of the cup body is provided with the second LED light emitting chip.

Preferably,
the light string includes 1000 LED luminous bodies in parallel, having an operating voltage of 24V and a total power being a level of 7W.
In summary, the light string of the present disclosure can be operated at a current of 0.3 mA or less, and even if a minimum operating current of ordinary LED light beads is 0.1 mA, the light string of the present disclosure can be operated normally as a decorative lamp or the like. Taking an operating voltage of 24V and a total of 1000 LED luminous bodies as an example, according to the series-parallel solution in the prior art, the total current of all parallel branches is about 0.75 A and the total power of the light string reaches 18W, and if the fully parallel solution with the current-limiting IC chips in the prior art is adopted instead, the total current of all parallel branches is about 3A and the total power of the light string reaches even 72W, while the total current of all parallel branches in the light string of the present disclosure is about 0.3 A and the total power of the light string can be as low as a level of 7W.

**BRIEF DESCRIPTION OF DRAWINGS**

In order to illustrate the technical solutions of the embodiments of the present disclosure more clearly, the drawings required for use in the embodiments will be briefly described below, and it should be understood that the following drawings illustrate only certain embodiments of the present disclosure and are therefore not to be construed as limiting the scope, and that other related drawings can be derived from these drawings for those of ordinary skill in the art without inventive step.

FIG. 1 is a schematic diagram of an LED luminous body in the light string according to an embodiment of the present disclosure;
FIG. 2 is a schematic diagram of the light string according to another embodiment of the present disclosure;
FIGS. 3 and 4 are schematic diagrams of two in-line LED luminous bodies of Φ5 according to different embodiments of the present disclosure;
FIG. 5 is a schematic diagram of the interior of the two in-line LED luminous bodies of Φ5 shown in FIGS. 3 and 4; and
FIG. 6 is a schematic diagram of an LED luminous body in the light string according to another embodiment of the present disclosure and another lamp cup thereof.

It should be noted that the above drawings do not limit the dimensional proportions between wires, LED luminous bodies, various components, and other parts, and the drawings are more illustrative of structures, connection relationships, spatial positional relationships, and the like.

**DETAILED DESCRIPTION OF THE INVENTION**

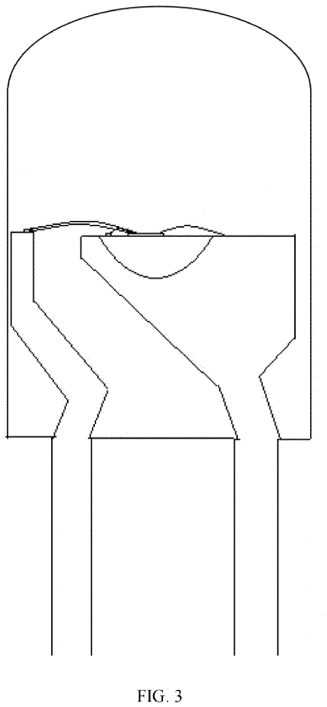

In order to make the objects, technical solutions and advantages of the embodiments of the present disclosure more clear, the technical solutions in the embodiments of the present disclosure will be clearly and completely described below in conjunction with FIGS. 3 to 6 in the embodiments of the present disclosure, and obviously, the described embodiments are a part of the embodiments of the present disclosure, rather than all of the embodiments. The components in the embodiments of the present disclosure as generally described and illustrated in the figures herein can be arranged and designed in a variety of different configurations.

Thus, the following detailed description of the embodiments of the present disclosure provided in the drawings is not intended to limit the scope of the claimed disclosure, but merely represents selected embodiments of the present disclosure. Based on the embodiments in the present disclosure, all other embodiments obtained by those of ordinary skill in the art without making inventive step belong to the scope of protection of the present disclosure.

It should be noted that like reference numerals and letters represent like items in the following figures, and therefore, once an item is defined in one figure, it need not be further defined and explained in subsequent figures.

In the description of the present disclosure, it should be noted that if the orientation or positional relationship indicated by the terms "upper", "lower", "inner", "outer", etc. is based on the orientation or positional relationship shown in the drawings, or the orientation or positional relationship conventionally placed during use of the product of the present disclosure, merely for ease of description of the present disclosure and for simplicity of description, but is not intended to indicate or imply that the referred device or element must have a particular orientation, and be constructed and operate in a particular orientation, and therefore is not to be construed as limiting the present disclosure.

Furthermore, the terms "first," "second," etc., where present, are used only to distinguish description and are not to be construed as indicating or implying relative importance.

It should be noted that the features in the embodiments of the present disclosure may be combined with each other without conflict.

In one embodiment, the present disclosure discloses a light string with reduced power consumption and improved brightness, including:

at least a first LED luminous body and a second LED luminous body in parallel, wherein
each LED luminous body includes at least a resistor, a first LED light emitting chip and a second LED light emitting chip, and each LED luminous body is free of current-limiting IC chip, wherein
the first LED light emitting chip and the second LED light emitting chip each include a plurality of LED light beads of the same specification in series, the first LED light emitting chip includes m LED light beads in series, and the second LED light emitting chip includes n LED light beads in series,
the resistor is in a series relationship with the first LED light emitting chip and the second LED light emitting chip,
a direct-current operating voltage of the light string is $V_s$, a target operating current If of the first LED light emitting chip and a target operating current If of the second LED light emitting chip are equal and are less than or equal to 0.3 mA, and an operating voltage of any one LED light bead in the first LED light emitting chip and the second LED light emitting chip is V:

a resistance value $R_s$ of the resistor is selected according to the following formula:

$$R_s=(V_s-m*V-n*V)/I_f,$$

and the operating voltage V of any one LED light bead is slightly less than or equal to a forward voltage $V_\varepsilon$ of the LED light bead.

The above embodiment embodies the core concept of the present disclosure: 1) the LED luminous bodies are in a parallel relationship, so as to realize arbitrary cutting of the light string; 2) each LED luminous body includes at least the resistor, the first LED light emitting chip and the second LED light emitting chip, and each LED luminous body is free of current-limiting IC chip, thereby significantly reducing the power consumption of the light string as no current-limiting IC chip is required, and the target operating currents If of the LED light emitting chips are equal and less than or equal to 0.3 mA, and the resistance value $R_s$ of the resistor is selected according to the following formula: $R_s=(V_s-m*V-n*V)/I_f$ to achieve the constraint relationship of related elements, thereby not only reducing the power consumption of the light string but still improving the brightness consistency of all the light beads on the premise that all the LED light beads in the LED light emitting chips are in a series relationship. For example, if the forward voltage $V_\varepsilon$ of the LED light bead is 3V, the operating voltage V of any one LED light bead may be 2.9 V, 2.8 V, or the like. Thus, the operating voltage V of any one LED light bead is greater than or equal to 0.8 $V_f$ and is less than or equal to the forward voltage $V_\varepsilon$ of the LED light bead, more preferably, the operating voltage V of any one LED light bead is greater than or equal to 0.9 $V_f$ and is less than or equal to the forward voltage $V_\varepsilon$ of the LED light bead.

Taking an operating voltage of 24V and a total of 1000 LED luminous bodies as an example, according to the series-parallel solution in the prior art, the total current of all parallel branches is about 0.75 A and the total power of the light string reaches 18W, and if the fully parallel solution with the current-limiting IC chips in the prior art is adopted instead, the total current of all parallel branches is about 3A and the total power of the light string reaches even 72W, and this solution results in a high cost due to the use of the current-limiting IC chips, while the total current of all parallel branches in the light string of the present disclosure is about 0.3 A and the total power of the light string can be as low as a level of 7W and the cost is low, as detailed hereinafter.

In another embodiment, the forward voltage $V_\varepsilon$ of the LED light bead is 3V. Exemplarily, the LED light beads are commercially available 5208 series patch-type light beads, or other models of ordinary LED patch-type light beads of 3V.

In another embodiment, the direct-current operating voltage $V_s$ of the light string is greater than or equal to 24 V and less than or equal to 36 V.

In another embodiment, m is not equal to n.

In another embodiment, m is 6 and n is 3.

In another embodiment, the resistance value $R_s$ of the resistor is 600 ohms.

Exemplarily, for LED light beads of 3V, six LED light beads of 3V are connected in series to form the first LED light emitting chip, and three LED light beads of 3V are connected in series to form the second LED light emitting chip, the first LED light emitting chip and the second LED light emitting chip are further connected in series with the resistor of 600 ohms to form the LED luminous body, and then a plurality of parallel LED luminous bodies can be operated at an operating voltage of 24V to 36V. As previously mentioned, taking an operating voltage of 24V and a total of 1000 LED luminous bodies in parallel as an example, when the operating current is 0.3 mA, a power consumed on the resistor is almost negligible, and the total power of the light string of the present disclosure can be approximately 24V*0.3 mA* 1000, i.e., 7.2 W, which is equivalent to a level of 7W. It should be noted that the first LED light emitting chip formed by the six LED light beads of 3V connected in series and the second LED light emitting chip formed by the three LED light beads of 3V connected in series have a higher degree of integration and can take into account the cost compared with using three LED light emitting chips, each LED light emitting chip being formed by three LED light beads of 3V connected in series. Therefore, in a more preferred embodiment, each LED luminous body is formed by connecting the resistor, the first LED light emitting chip and the second LED light emitting chip in series.

In another embodiment,

each LED luminous body further includes a cup body, wherein
a side of a "+" end of the cup body is provided with the resistor and the first LED light emitting chip, and
a side of a "-" end of the cup body is provided with the second LED light emitting chip.

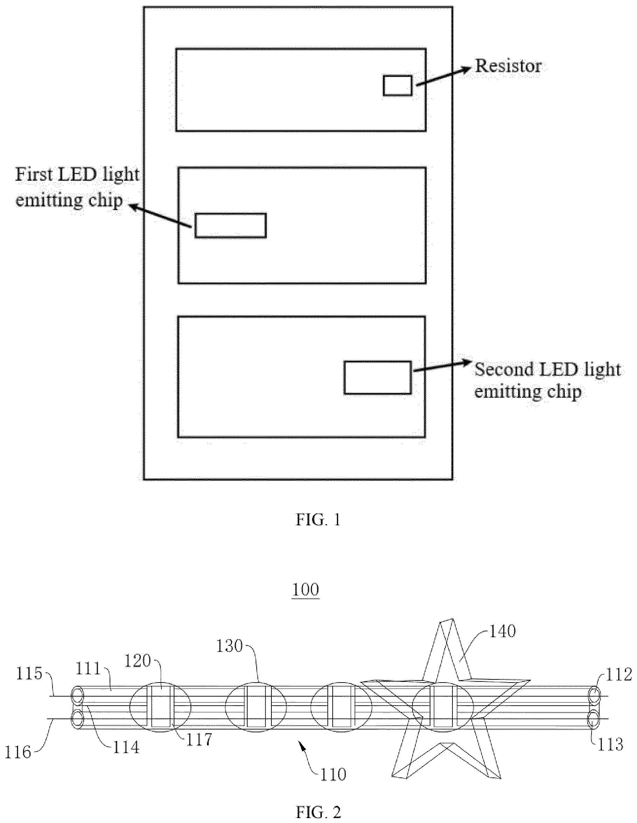

Referring to FIG. 1, in another embodiment,

for a lamp cup of each LED luminous body, one side of the lamp cup is a positive end and is used for being connected with a positive electrode of direct current, the other side of the lamp cup is a negative end and is used for being connected with a negative electrode of direct current, and the resistor, the first LED light emitting chip, and the second LED light emitting chip are disposed on the lamp cup, and on the lamp cup: a first insulation slot is formed between the resistor and the first LED light emitting chip, and a second insulation slot is formed between the first LED light emitting chip and the second LED light emitting chip;
the resistor is located in a first region of the cup body, the first LED light emitting chip is located in a second region of the cup body, the second LED light emitting chip is located in a third region of the cup body, the first insulation slot is located between the first region and the second region, and the second insulation slot is located between the second region and the third region,
the resistor is located on one side of a first region, the second LED light-emitting chip is located on the same side as the first region in the third region, and the first LED light emitting chip is located on a side opposite to the first region in the second region.

Thus, when the resistor, the first LED light emitting chip, and the second LED light emitting chip are arranged on the same layer of circuit board, the above embodiment can minimize the influence of circuit interference and heat as much as possible. Naturally, if necessary, the first LED light emitting chip and the second LED light emitting chip may also be arranged on the front and back sides of the circuit board.

Still further, in another embodiment,

the resistor is located at one corner of the first region, the second LED light emitting chip is located at one corner on the same side as the first region in the third region, and
the first LED light emitting chip is located at an opposite corner opposite to the first region in the second region.

Still further, in another embodiment,
the resistor and the LED light emitting chips are individually packaged or designed in a modular structure, and then electrically connected with each other after the electrical connection is completed internally, so that short circuits, interference, and the like can be significantly reduced.

In a more specific embodiment, referring to FIG. 2, in this embodiment, the present disclosure provides a light string 100 with reduced power consumption and improved brightness, including a power cord, a plurality of packages 130, and a plurality of LED luminous bodies 120. The plurality of the LED luminous bodies 120 are disposed at intervals along the extending direction of the power cord, and the plurality of LED luminous bodies 120 are respectively soldered and fixed to a conductor of the power cord to achieve electrical connection of the LED luminous bodies 120 to the conductor, satisfying the light emitting demands of the LED luminous bodies 120. At the same time, the plurality of the packages 130 are disposed in one-to-one correspondence with the plurality of the LED luminous bodies 120, and the packages 130 wrap the LED luminous bodies 120 and conductive pins between the LED luminous bodies 120 and the conductor, thereby protecting the LED luminous bodies 120 and providing the good waterproofing function, contributing to prolonging the service life of the light string 100. At the same time, the plurality of the LED luminous bodies 120 are in a parallel relationship, a product formed by the plurality of the LED luminous bodies 120 in parallel can be arbitrarily cut according to the requirements, which is convenient for use and maintenance, and has better user experience.

The light string 100 provided by this embodiment is further described below:
Continuing to refer to FIG. 2, in this embodiment, a light string line 110 can have the characteristics of aging resistance, softness, good elasticity, etc., which helps to prolong the overall service life of the product. The conductor includes a positive electrode wire 115 and a negative electrode wire 116, while the light string line 110 further includes an insulating layer 111 wrapped around the positive electrode wire 115 and the negative electrode wire 116 and having a conductive site 117, thereby exposing the positive electrode wire 115 and the negative electrode wire 116 at the conductive site 117. The LED luminous bodies 120 are disposed at the conductive site 117 to be in contact with the positive electrode wire 115 and the negative electrode wire 116, thereby realizing a conductive connection of the LED luminous bodies 120 with the positive electrode wire 115 and the negative electrode wire 116. A plurality of conductive sites 117 are disposed at intervals on the insulating layer 111, the plurality of the LED luminous bodies 120 are disposed at the plurality of the conductive sites 117 in one-to-one correspondence, and each LED luminous body 120 is conductively connected with the positive electrode wire 115 and the negative electrode wire 116, thus, the plurality of the LED luminous bodies 120 in the manufactured light string 100 are connected in parallel to each other, and can be cut according to the demand when used, and the required number of LED luminous bodies 120 is retained, so as to avoid cutting similar products formed by series connection according to the specified unit or the number of lamps, because if the light string formed by series connection is cut incorrectly, the problem that a section of lamps will not light up is caused.

Specifically, during production, the insulating layer 111 of the light string line 110 may be cut by using a combined blade to form the conductive sites 117 that expose the positive electrode wire 115 and the negative electrode wire 116. The LED luminous bodies 120 are then soldered and fixed to the positive electrode wire 115 and the negative electrode wire 116 at the conductive sites 117, thereby realizing the conductive connection of the LED luminous bodies 120 to the positive electrode wire 115 and the negative electrode wire 116. After soldering is completed, the LED luminous bodies 120 and the conductive sites 117 are enclosed within the packages 130 by wrapping the packages 130 around the conductive sites 117 to achieve a waterproof and protective function. In addition, this also indicates that during the production of the light string 100, the positive electrode wire 115 and the negative electrode wire 116 can be connected to the bottom, and it is not necessary to use two sections of pre-cut wires on both sides of each LED luminous body to connect the corresponding LED luminous bodies, which is obviously beneficial to the improvement of manufacturing efficiency: it is only necessary to prepare sufficiently long positive and negative electrode wires to connect the conductive sites with the corresponding conductive pins of the LED luminous bodies, for example, soldering, after soft insulating layers are removed in advance at the corresponding conductive sites.

It should be noted that for each LED luminous body 120, a plurality of the conductive sites 117 may be provided, for example, four, so as to correspondingly connect the first LED light emitting chip and the second LED light emitting chip in the LED luminous body 120; the combined blade cuts the corresponding insulating layers at four different locations in multiple times to form first, second, third, and fourth conductive sites. Optionally, the combined blade may include two blades, and a positioning device, such as an optical or visual positioning device, may also be combined to position the cutting position and drive a manipulator to bring the blades to the target position to cut the insulating layer. Further, the manipulator may further strip the peripheral insulating layer at the conductive sites to facilitate the connection of the conductive pins of the LED luminous bodies to the conductive sites. Further, in order to more accurately cut the electrode wires to remove the insulating layer to expose the conductive sites, the optical or visual positioning device incorporating the AI technology may be employed to accurately locate and realize cutting and stripping of the insulating layer. The advantages of precise cutting to form the conductive sites are as follows: on one hand, a corresponding electrical connection can be formed for two LED light emitting chips in a single LED luminous body; on the other hand, in non-electrically connected regions, the structure of the corresponding wire itself is protected as much as possible.

Optionally, after soldering is completed, the packages 130 are formed with glue at the conductive sites 117. At the same time, the packages 130 have a spherical structure. The LED luminous bodies 120 are completely enclosed in the packages 130, and the positive electrode wire 115 and the negative electrode wire 116 exposed at the conductive sites 117 are also wrapped by the packages 130, and the glue can well bonded to the light string line 110, thereby ensuring the waterproof effect and protection of the LED luminous bodies 120. Further, in order to further ensure the appearance and the effect, other shapes of housings may sleeve the packages 130. Alternatively, the exteriors of the packages 130 may be molded by injection molding. A shape 140 shown in FIG. 1 has a star shape, and it can be understood that in other embodiments, the shape 140 may be specifically set as needed, such as a heart shape, a tree shape, or the like.

Further, the insulating layer 111 is provided with a first channel 112 and a second channel 113 which are independent from each other, and the positive electrode wire 115 penetrates through the first channel 112, and the negative electrode wire 116 penetrates through the second channel 113. The conductive sites 117 simultaneously communicate with both the first channel 112 and the second channel 113, so that the LED luminous bodies 120 disposed at the conductive sites 117 can be conductively connected with both the positive electrode wire 115 in the first channel 112 and the negative electrode wire 116 in the second channel 113. Exemplarily, the insulating layer 111 includes a first cylindrical part, a second cylindrical part and a connecting part 114 arranged between the first cylindrical part and the second cylindrical part. The first cylindrical part is a circular tubular member in which the first channel 112 is formed; and the second cylindrical part is a circular tubular member in which the second channel 113 is formed.

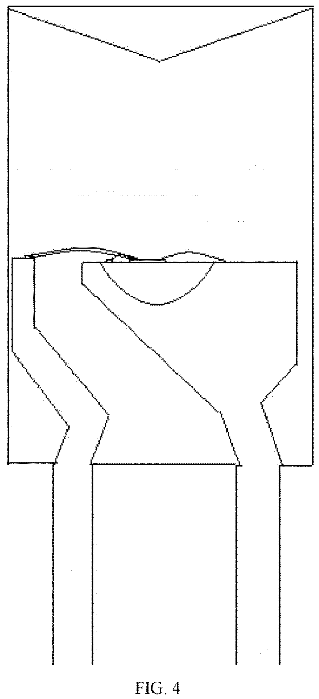

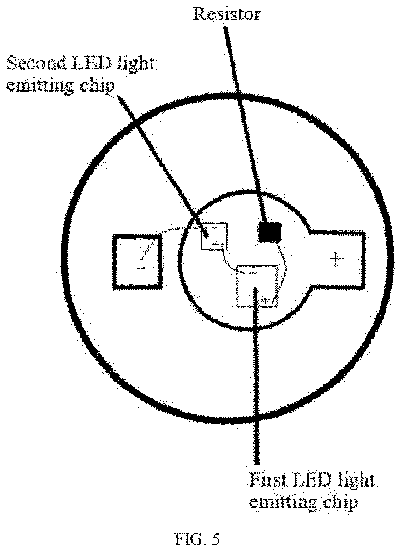

Referring to FIGS. 3 and 4, which illustrate two in-line LED luminous bodies of Φ5, which can be operated at an operating voltage of 24V, and further referring to FIG. 5, which illustrates the resistor, the first LED light emitting chip, and the second LED light emitting chip included in the above two in-line LED luminous bodies of Φ5, wherein the first LED light emitting chip is formed, for example, by six LED light beads of 3V connected in series, and the second LED light emitting chip is formed, for example, by three LED light beads of 3V connected in series.

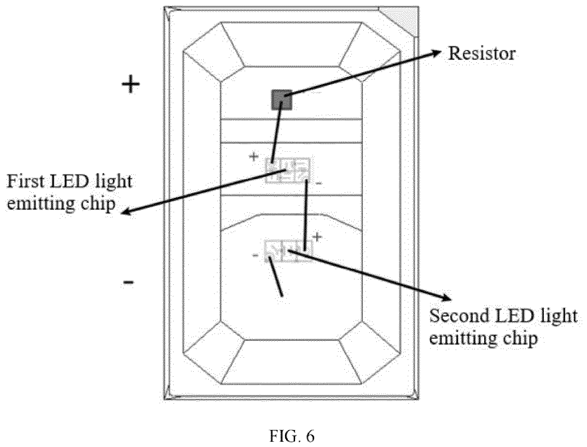

Referring to FIG. 6, in another embodiment, the present disclosure also discloses LED luminous bodies in the light string and another lamp cup thereof. For example, the resistance is 600 ohms, and it can be understood that the resistance can be flexibly adjusted as needed, for example according to the formula $R_s=(V_s-m*V-n*V)/I_f$ as described above. Exemplarily, the first LED light emitting chip is formed by six LED light beads of 3V connected in series and the second LED light emitting chip is formed by three LED light beads of 3V connected in series.

The above description is only specific embodiments of the present disclosure, but the protection scope of the present disclosure is not limited thereto, and any variations or substitutions easily conceivable by those skilled in the art within the technical scope of the present disclosure should be covered by the protection scope of the present disclosure. Therefore, the protection scope of the present disclosure should be subject to the protection scope of the claims.

**Claims**

1. A light string with reduced power consumption and improved brightness, comprising:

   at least a first LED luminous body and a second

**EP 4 601 417 A1**

LED luminous body connected in parallel, wherein

each LED luminous body comprises at least a resistor, a first LED light emitting chip and a second LED light emitting chip, and no current-limiting IC chip is provided for each LED luminous body, wherein

the first LED light emitting chip and the second LED light emitting chip each comprise a plurality of LED light beads which are of the same specification and are connected in series, the first LED light emitting chip comprises m LED light beads in series, and the second LED light emitting chip comprises n LED light beads in series, the resistor is connected in series with the first LED light emitting chip and the second LED light emitting chip,

a resistance value $R_s$ of the resistor is selected according to the following formula:

$$R_s = (V_s - m*V - n*V)/I_f,$$

wherein a direct-current operating voltage of the light string is $V_s$, a target operating current of the first LED light emitting chip is equal to a target operating current of the second LED light emitting chip, which is If and is less than or equal to 0.3 mA, and an operating voltage of any one LED light bead in the first LED light emitting chip and the second LED light emitting chip is V:
and the operating voltage V of any one LED light bead is slightly less than or equal to a forward voltage $V\epsilon$ of the LED light bead.

2. The light string according to claim 1, wherein preferably,
   the forward voltage $V\epsilon$ of the LED light bead is 3V.

3. The light string according to claim 1, wherein
   the direct-current operating voltage $V_s$ of the light string is greater than or equal to 24 V and is less than or equal to 36 V.

4. The light string according to claim 1, wherein
   m is not equal to n.

5. The light string according to claim 1, wherein
   m is 6 and n is 3.

6. The light string according to claim 1, wherein
   the resistance value $R_s$ of the resistor is 600 ohms.

7. The light string according to claim 1, wherein

   each LED luminous body further comprises a cup body, wherein
   a side of a "+" end of the cup body is provided with the resistor and the first LED light emitting chip, and
a side of a "-" end of the cup body is provided with the second LED light emitting chip.

8. The light string according to claim 1, wherein
   the light string comprises 1000 LED luminous bodies in parallel, and the light string has an operating voltage of 24V and a total power in a level of 7W.

Resistor

First LED light
emitting chip

Second LED light
emitting chip

FIG. 1

100

115   111   120   130   140

112

116   114   117   110   113

FIG. 2

FIG. 3

FIG. 4

Resistor

Second LED light
emitting chip

First LED light
emitting chip

FIG. 5

FIG. 6

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/007679 A1 (ALLEN DAVID [US]) 12 January 2006 (2006-01-12) * paragraphs [0093] - [0094], [0096], [0128]; figures 1A, 2A, 3A, 8A, 8B * ----- | 1-8 | INV. H05B45/40 |
| X | US 2023/413402 A1 (WU QINGAN [CN] ET AL) 21 December 2023 (2023-12-21) * paragraph [0006] - paragraph [0035]; figures 1-3 * ----- | 1-8 | |

**TECHNICAL FIELDS SEARCHED    (IPC)**

H05B
F21V
F21S

The present search report has been drawn up for all claims

| Place of search | Date of completion of the search | Examiner |
|---|---|---|
| Munich | 2 July 2025 | Hernandez Serna, J |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 22 3276

This annex lists the patent family members relating to the patent documents cited in the above-mentioned European search report.
The members are as contained in the European Patent Office EDP file on
The European Patent Office is in no way liable for these particulars which are merely given for the purpose of information.

02-07-2025

| Patent document cited in search report | Publication date | Patent family member(s) | | Publication date |
|---|---|---|---|---|
| US 2006007679 A1 | 12-01-2006 | CA | 2475625 A1 | 21-04-2005 |
| | | CN | 1641899 A | 20-07-2005 |
| | | US | 2004165384 A1 | 26-08-2004 |
| | | US | 2006007679 A1 | 12-01-2006 |
| | | US | 2006139920 A1 | 29-06-2006 |
| | | US | 2006203482 A1 | 14-09-2006 |
| | | US | 2007263387 A1 | 15-11-2007 |
| | | US | 2011211353 A1 | 01-09-2011 |
| | | US | 2013010475 A1 | 10-01-2013 |
| | | US | 2015003062 A1 | 01-01-2015 |
| | | US | 2016351763 A1 | 01-12-2016 |
| US 2023413402 A1 | 21-12-2023 | CA | 3166718 A1 | 16-12-2023 |
| | | CN | 115127047 A | 30-09-2022 |
| | | US | 2023413402 A1 | 21-12-2023 |

EPO FORM P0459

For more details about this annex : see Official Journal of the European Patent Office, No. 12/82